# EUROPEAN PATENT SPECIFICATION

(11) **EP 3 010 101 B1**
(45) Date of publication and mention of the grant of the patent: **10.10.2018**
(21) Application number: 14003563.5
(22) Date of filing: 17.10.2014
(51) Int. Cl.: H02B 1/30, H02B 13/065, G01J 5/00, H02B 3/00

(54) **Air insulated medium voltage switchgear, and probe system for air insulated medium voltage switchgear**
Luftisolierte Mittelspannungsschaltanlage und Sondensystem für eine luftisolierte Mittelspannungsschaltanlage
Appareillage de commutation de tension moyenne isolée par air et système de sonde pour appareillage de commutation de tension moyenne isolée par air

(43) Date of publication of application: 20.04.2016
(73) Proprietor: ABB Schweiz AG, 5400 Baden (CH)
(72) Inventor: Kozel, Tomas, 63500 Brno (CZ)
(74) Representative: Schmidt, Karl Michael

(56) References cited:
- WO-A1-2014/102684
- DE-A1- 4 108 588
- DE-A1- 19 747 826

## Description

The invention relates to an Air insulated medium voltage switchgear, and a probe system for air insulated medium voltage switchgear, wherein the probe system is a portable probe system, which can be inserted through a separate opening of the housing of the switchgear, and that the switchgear housing contains a low voltage steering compartment and a medium voltage compartment, according to the preamble of claim 1.
Current problems in Medium Voltage Switchgear condition monitoring are described as follows
- Partial discharge cannot be detected by externally attached equipment, which is insensitive. Its applicable to cable and circuit breaker compartment, but usually not easily applicable to busbar compartment due to its location inside the switchgear housing.
- Infrared thermal imaging is applicable to cable connections - in cable compartment - only, but usually not easily applicable to circuit breaker and busbar compartment.
- No standard solution of permanently installed condition monitoring devices in the circuit breaker and busbar compartments is availabe. Normally the monitoring electronics equipments life cycle is much shorter then the switchgear life cycle. The shorter electronics lifecycle would cause troubles demanding shutdowns of the switchgear for failed electronics replacement rather then help the users reduce the need for shutdowns.
In the DE 41 08 588 A1 is disclosed a fixed temperature sensor means comprising an optical fiber inserted through a hole of the housing of the switchgear.

CN201134617Y discloses a busbar condition monitoring system of a medium voltage switchgear comprising fixed current and temperature sensors in the busbar compartment.

DE 19747826A1 discloses permanently mounted pressure sensors in the control compartment of a switchgear, which are connected via tubes to the busbar and circuit breaker compartments.

So it is the object of the invention to overcome this problems in common.

The solution by the invention defined by claim 1 is, that the separate opening for the probe is located in such, that it guides through the low voltage control compartment into the medium voltage compartment or compartments of the switchgear.
Furthermore the separate opening is provided with a mechanical shutter, and the shutter is proved with locking means in such, to prevent unauthorized use. Unauthorized use should be blocked in order to prevent that unskilled person can insert object into the switchgear compartments.
In a further advantageous embodiment, the probe system can be directly pluged in electrically during it is passed through the low voltage compartment. So the probe sensors will be activated simultaneously.
In a further advantageous embodiment the pass through for the probe system into the switchgear is arranged in such, that after having inserted the probe system along a first short distance, the head of the probe reaches the circuit breaker compartment of the medium voltage compartment, and then after a further and deaper insertation the probe system reaches the busbar compartment.
Advantageous is, that the opening is designed in a circular form in such, that the probe system can be rotated around its long axis after insertion. In a further advantageous embodiment, the used probe system is portable and for temporarily use provided with a pair of sensors, that means one ultrasonic sensor for partial discharge detection, and one infrared sensor for assessment of joints of temperature.
In a last advantageous embodiment, the arrangement of the opening is retrofitted. So by this, and by the embodiment of a portable sensor probe, retrofitting of existing switchgear systems is possible.

An embodiment of the invention is shown in the figures. Internal arc safe opening according to the invention allows partial discharge measuring equipment and infrared thermography equipment in internal arc resistant probe temporarily or permanently to circuit breaker and busbar compartment.
So by monitoring an infrared image of the internal compartment of the switches and busbars high transition resistance can be monitored and therefore located as soon symptome of faults, as well as detection of ultrasonic sensor field inside the switchgear if the probe is provided with an ultrasonic sensor.
The invention solves furthermore the already above mentioned problems, in current medium voltage air insulated switchgear condition monitoring methods - pointwise:
- The partial discharge ultrasonic sensor in the probe, inserted through the opening, has direct airpath to the circuit breaker or busbar compartment allowing accurate measurement of ultrasonic signal levels in these compartments.
- The infrared thermal imaging equipment in the probe, inserted through the opening, has the critical areas in the circuit breaker or busbar compartment in direct field of view allowing accurate thermal imaging without need for any infrared windows.
- The probe with ultrasonic and infrared thermal imaging equipment can be inserted permanently into the opening. In case some of the monitoring equipment inside the probe fails, the probe can be replaced with spare one in matter of minutes without a need for switchgear shutdown.

So the use of dedicated internal arc safe opening with shutter system for entry of the condition monitoring equipment to the circuit breaker and busbar compartment is basical for the invention.
Furthermore the use of dedicated interal arc safe probe with monitoring equipment embedded in it for periodic condition assessment or permanent condition monitoring of the medium voltage air insulated condition.

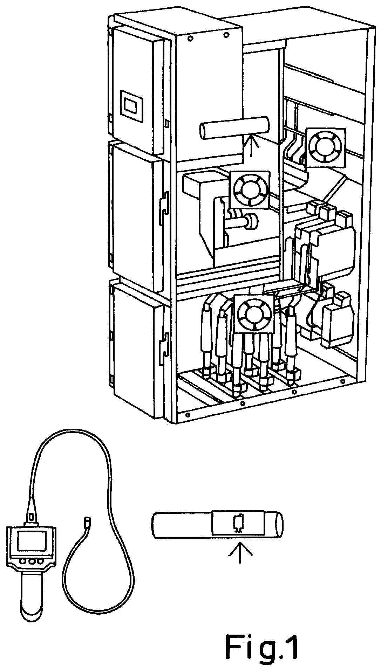

Figure 1 shows an air insulated medium voltage switchgear housing in transparent side view.
The sensor probe is here indicated as inserted into the circuit breaker compartment. The probe is here provided with an endoskopic camera, in order to have a look downwards, as indicated. An externally holded camera is connected with the probe, so that images from inside the compartment can be transmitted to the external display.

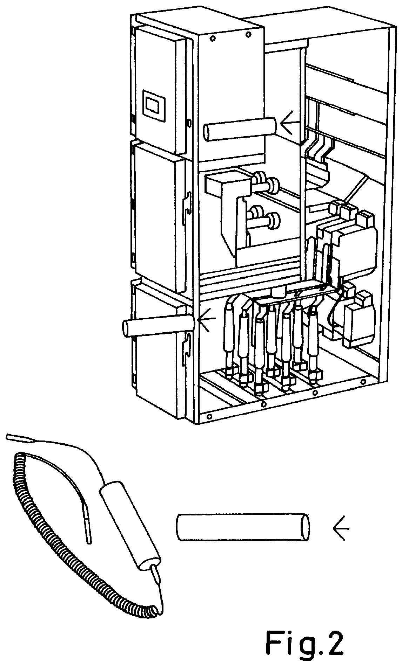

Figure 2 shows different positions of the probe in the switchgear housing/compartment.
So the probe can be provided with an ultrasonic sensor system.

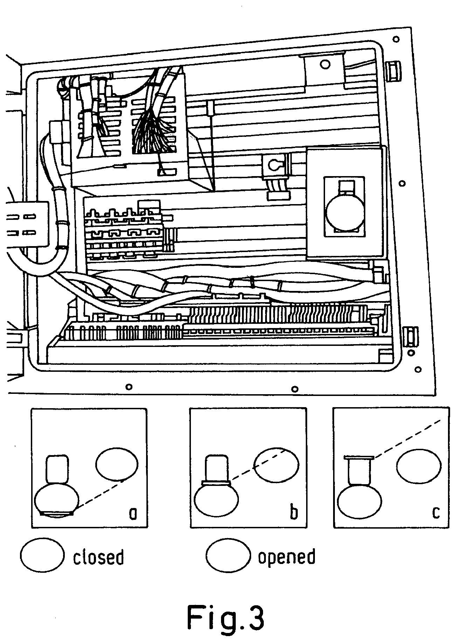

Figure 3 shows the opening for inserting the probe into the low-voltage compartment of the switchgear.
So the entry for diagnostic tools should be internal arc safe, i.g. the shutter, in fact two shutters, which are mechanically interlinked, one between the low voltage compartment and the circuitbreaker compartment, and the busbar compartment.
So the shutters can have the following open positions in combination.
a) The entry to circuit breaker compartment is closed and the entry to busbar compartment is closed.
b) The entry to circuit breaker compartment is opened, and the entry to busbar compartment is closed.
c) The entry to circuit breaker compartment and busbar compartment is opened.

The condition monitoring opening is a dedicated opening for inserting condition monitoring equipment in a probe to circuit breaker and busbar compartments. When not in use, the opening is covered by a internal arc proof shutter to provide arc safety for the personnel. The probe containing condition monitoring sensors when inserted in the opening also ensures the intenal arc proofing. The detailed design of the shutter mentioned above is not in scope of this invention disclosure, as different design migh be applied.

The inlet location is preferably in the central right part of low voltage (LV) compartment of the switchgear, so that the monitoring equipment signals (in case of permanently inserted probe) can be routed shortest way to the signal processing units located in LV compartment. In case of temporarily inserted probe, the LV compartment central right part is easily accessible for the operator and usually provides routing for the probe that do not dramaticaly distort the electromagnetic field in circuit breaker and busbar compartments.
The opening described above leads from the LV compartment (Low voltage compartment) to the circuit breaker compartment. For entry to busbar compartment, similar opening with shutter (this shutter doesn't have to be arc proof and should be preferrably operated by the same mechanism as the inlet from LV to circuit breaker compartment) needs to be provided between circuit breaker and busbar compartments to allow access for the probe from circuit breaker to busbar compartment.
Both openings have preferably circular form, so that the monitoring equipment can be fixed into a probe in form of metal tube and the probe can be rotated into desired position once inserted into the opening. When used for periodic condition assessments (temporarily), the probe is fitted with one pair of sensors (ultrasonic for partial discharge and IR or visible spectrum camera for assessment of joints temperature). The method of taking measurements for periodic condition assessment is the following: The operator opens the shutter on the opening between LV and circuit breaker compartments and inserts the probe "half way", i.e. into the circuit breaker compartment taking measurements in circuit breaker compartment. With the probe still inserted "half way" in the circuit breaker compartment, the operator opens the shutter between circuit breaker and busbar compartment and insert the probe full way to the busbar compartment for taking measurements there. On the way out the shutters close automatically once the probe is removed from the inlet.
When used for permanent condition monitoring (the probe is permanently inserted in the opening full way), the probe is fitted with two sets of sensors and with plug and socket system on the operator (LV compartment) end, so that once fully inserted into the opening, one pair of sensors monitors the busbar compartment, second pair of sensors monitors the circuit breaker compartment and the signals are wired through the plug and socket system to the signal processing unit in LV compartment.

The detailed setup of sensors in the probes and used sensor technology is not in scope of this disclosure, as the sensing technologies might develop in time while the method of inserting the sensor in a probe through the dedicated inlet stays the same.
The shutter on the opening is lockable (in fully closed position) by padlock or dedicated key lock to prevent unauthorized person opening the opening.

## Claims

1. Air insulated medium voltage switchgear, and a probe system for air insulated medium voltage switchgear, wherein the probe system is a portable probe system applied for condition monitoring, which can be inserted through a separate opening of the housing of the switchgear, and that the switchgear housing contains a low voltage control compartment and a medium voltage compartment,
**characterized in,**
**that** the separate opening for the probe system is located in such, that it guides the portable probe system through the low voltage control compartment into the medium voltage compartment or compartments of the switchgear,
during insertion of the probe system into the opening, and
**that** the separate opening is provided with a mechanical shutter, and that the shutter is proved with locking means in such, to prevent unauthorized use.

2. Air insulated medium voltage switchgear, according to claim 1,
**characterized in**
**that** the probe system can be directly pluged in electrically during it is passed through the low voltage compartment.

3. Air insulated medium voltage switchgear, according to one of the aforesaid claims,
**characterized in**
**that** the pass through for the probe system into the switchgear is arranged in such, that after having inserted the probe system along a first short distance, the head of the probe reaches the circuit breaker compartment of the medium voltage compartment, and then after a further and deaper insertation the probe system reaches the busbar compartment.

4. Air insulated medium voltage switchgear, according to one of the aforesaid claims,
**characterized in**
**that** the opening is designed in a circular form in such, that the probe system can be rotated around its long axis after insertation.

5. Air insulated medium voltage switchgear, according to one of the aforesaid claims,
**characterized in**
**that** the used probe system is portable and for temporarily use provided with a pair of sensors, that means one ultrasonic sensor for partial discharge detection, and one infrared sensor for assessment of joints of temperature.

6. Air insulated medium voltage switchgear, according to one of the aforesaid claims,
**characterized in**
**that** the arrangement of the opening is retrofitted.

## Patentansprüche

1. Luftisolierte Mittelspannungsschaltanlage und Sondensystem für eine luftisolierte Mittelspannungsschaltanlage, wobei das Sondensystem ein tragbares Sondensystem zur Zustandsüberwachung ist, das durch eine gesonderte Öffnung des Gehäuses der Schaltanlage einsetzbar ist, und wobei das Schaltanlagengehäuse ein Niederspannungssteuerkammer und eine Mittelspannungskammer enthält,
**dadurch gekennzeichnet,**
**dass** die gesonderte Öffnung für das Sondensystem derart angeordnet ist, dass sie das tragbare Sondensystem während des Einsetzens des Sondensystems in die Öffnung durch die Niederspannungssteuerkammer in die Mittelspannungskammer oder -kammern der Schaltanlage führt, und dass die gesonderte Öffnung mit einem mechanischen Verschluss versehen ist, und dass der Verschluss mit einer solchen Verriegelung versehen ist, die eine unbefugte Benutzung verhindert.

2. Luftisolierte Mittelspannungsschaltanlage nach Anspruch 1,
**dadurch gekennzeichnet,**
**dass** das Sondensystem direkt elektrisch angeschlossen werden kann, während es durch die Niederspannungskammer geführt wird.

3. Luftisolierte Mittelspannungsschaltanlage nach einem der vorhergehenden Ansprüche,
**dadurch gekennzeichnet,**
**dass** der Durchlass für das Sondensystem in die Schaltanlage derart angeordnet ist, dass nach dem Einsetzen des Sondensystems entlang einer ersten kurzen Strecke der Kopf der Sonde die Leistungsschalterkammer der Mittelspannungskammer erreicht und das Sondensystem dann nach einem weiteren und tieferen Einführen die Sammelschienenkammer erreicht.

4. Luftisolierte Mittelspannungsschaltanlage nach einem der vorhergehenden Ansprüche,
**dadurch gekennzeichnet,**
**dass** die Öffnung derart kreisförmig ausgestaltet ist, dass das Sondensystem nach dem Einsetzen um seine Längsachse drehbar ist.

5. Luftisolierte Mittelspannungsschaltanlage nach einem der vorhergehenden Ansprüche,
**dadurch gekennzeichnet,**
**dass** das verwendete Sondensystem tragbar ist und zur vorübergehenden Verwendung mit einem Paar von Sensoren bereitgestellt wird, nämlich mit einem Ultraschallsensor zur Erkennung von Teilentladungen und einem Infrarotsensor zur Bewertung von Temperaturverbindungen.

6. Luftisolierte Mittelspannungsschaltanlage nach einem der vorhergehenden Ansprüche,
**dadurch gekennzeichnet,**
**dass** die Anordnung der Öffnung nachgerüstet wird.

## Revendications

1. Appareillage de commutation à moyenne tension isolé à l'air et système de sonde pour appareillage de commutation à moyenne tension isolé à l'air, dans lequel le système de sonde est un système de sonde portable utilisé pour la surveillance de l'état, qui peut être inséré par une ouverture séparée du boîtier de l'appareillage de commutation, et où le boîtier de l'appareillage comporte un compartiment de commande à basse tension et un compartiment à moyenne tension,
**caractérisé en ce que**
l'ouverture séparée pour le système de sonde est située de telle sorte qu'elle guide le système de sonde portable à travers le compartiment de commande à basse tension dans le ou les compartiments à moyenne tension de l'appareillage de commutation, pendant l'insertion du système de sonde dans l'ouverture, et
**en ce que** l'ouverture séparée est munie d'un obturateur mécanique, et **en ce que**
l'obturateur est sécurisé par des moyens de verrouillage pour empêcher une utilisation non autorisée.

2. Appareillage de commutation à moyenne tension isolé à l'air selon la revendication 1,
**caractérisé en ce que**
le système de sonde peut être directement branché électriquement pendant qu'il traverse le compartiment à basse tension.

3. Appareillage de commutation à moyenne tension isolé à l'air, selon l'une quelconque des revendications précédentes,
**caractérisé en ce que**
le passage du système de sonde dans l'appareillage est agencé de telle sorte qu'après avoir inséré le système de sonde sur une première courte distance, la tête de la sonde atteigne le compartiment des disjoncteurs du compartiment à moyenne tension, puis après insertion plus profonde le système de sonde atteigne le compartiment du jeu de barres.

4. Appareillage de commutation à moyenne tension isolé à l'air, selon l'une des revendications précédentes,
**caractérisé en ce que**
l'ouverture est conçue sous une forme circulaire de telle sorte que le système de sonde puisse tourner autour de son axe long après l'insertion.

5. Appareillage de commutation à moyenne tension isolé à l'air, selon l'une des revendications précédentes,
**caractérisé en ce que**
le système de sonde utilisé est portable et, pour une utilisation temporaire, équipé d'une paire de capteurs, c'est-à-dire un capteur à ultrasons pour la détection des décharges partielles et un capteur à infrarouge pour l'évaluation des joints de température.

6. Appareillage de commutation à moyenne tension isolé à l'air, selon l'une quelconque des revendications précédentes,
**caractérisé en ce que**
la disposition de l'ouverture est installée ultérieurement.
